# EUROPEAN PATENT SPECIFICATION

(11) **EP 4 353 674 B1**
(45) Date of publication and mention of the grant of the patent: **25.02.2026**
(21) Application number: 22200958.1
(22) Date of filing: 11.10.2022
(51) Int. Cl.: B81B 7/00, B81C 1/00

(54) **METHOD FOR SEALING A MEMS DEVICE AND A SEALED MEMS DEVICE**
VERFAHREN ZUM ABDICHTEN EINER MEMS-VORRICHTUNG UND ABGEDICHTETE MEMS-VORRICHTUNG
PROCÉDÉ D'ÉTANCHÉIFICATION D'UN DISPOSITIF MEMS ET DISPOSITIF MEMS ÉTANCHE

(43) Date of publication of application: 17.04.2024
(73) Proprietor: Murata Manufacturing Co., Ltd., Nagaokakyo-shi, Kyoto 617-8555 (JP)
(72) Inventor: Iihola, Antti, 00950 Helsinki (FI); Lindroos, Jeanette, 00560 Finland (FI)
(74) Representative: Boco IP Oy Ab

(56) References cited:
- WO-A1-2011/111541

## Description

### FIELD OF THE DISCLOSURE

The present disclosure relates to microelectromechanical (MEMS) components, and more particularly to MEMS components with a sealed cavity. The present disclosure further concerns MEMS components where the cavities is sealed by eutectic bonding.

### BACKGROUND OF THE DISCLOSURE

Microelectromechanical devices include mobile structures etched in a silicon device wafer and electrical connections between the inside and outside of the device. These electrical connections may be connected to capacitive or piezoelectric actuators which are adjacent to the mobile structures in the device wafer. Such actuators can be used to generate forces that move the mobile structures and/or to measure their movement.

The device wafer is often bonded to a cap wafer so that the device structures can be sealed in a cavity with a controlled atmosphere. Possible bonding methods include fusion bonding, metallic bonding, glass-frit bonding, and anodic bonding, for example. One factor which influences the choice of bonding method is how the electrical connections should be drawn. It is often convenient to extend the electrical connections through the cap wafer, so that the MEMS devices in the component can be reached through electrical contacts placed on top of the cap wafer.

Document WO2011111541 discloses a MEMS sensor with a first substrate, a second substrate and an eutectic sealing/bonding section that is positioned between the aforementioned first substrate and the aforementioned second substrate.

### BRIEF DESCRIPTION OF THE DISCLOSURE

An object of the present disclosure is to provide a method and an apparatus for simultaneously sealing and contacting a MEMS device. The object of the disclosure is achieved by a method and an arrangement, which are characterized by what is stated in the independent claims. The preferred embodiments of the disclosure are disclosed in the dependent claims.

The disclosure is based on the idea of preparing device wafer structures, which allow the cavity to be sealed and electric connections to be made in the same metallic bonding process.

### BRIEF DESCRIPTION OF THE DRAWINGS

In the following, the disclosure will be described in greater detail by means of preferred embodiments with reference to the accompanying drawings, in which
Figures 1a - 1i illustrate manufacturing steps performed on the device wafer.
Figures 1j - 1k illustrate manufacturing steps performed on the cap wafer.
Figure 1l illustrates a manufacturing step where the device wafer and the cap wafer have been aligned with each other.
   The combination of the manufacturing steps of figures 1a-1l illustrate a method of production according to the invention.
Figure 2a - 2c illustrate sealed MEMS devices which are in accordance with the invention.
Figures 3a - 3b illustrate standoffs in a sealed MEMS device.

### DETAILED DESCRIPTION OF THE DISCLOSURE

This disclosure describes a method for sealing and contacting a microelectromechanical device. The device comprises a silicon device wafer with MEMS device structures and a cap wafer with an electrical circuit. The device wafer comprises a sealing region and an interconnection region. The cap wafer comprises a corresponding sealing region and interconnection region, and the electrical circuit extends to the interconnect region in the cap wafer. The method comprises the steps of:
Forming a first conductive part in the interconnection region of the device wafer so that the first conductive part is elevated above the main surface of the device wafer. Forming a layer of a first diffusion-preventing material on the device wafer and patterning this layer so that it is present in the sealing region of the device wafer. Depositing a layer of a first eutectic metal alloy material on the device wafer and patterning this layer so that it is present in the interconnection region of the device wafer on top of the first conductive part and in the sealing region of the device wafer on top of the first diffusion-preventing material. Depositing a layer of a second eutectic metal alloy material on the cap wafer and patterning this layer so that it is present in the sealing region of the cap wafer. Bonding the cap wafer to the device wafer so that the interconnection region of the device wafer is aligned with the interconnection region of the cap wafer and the sealing region of the device wafer is aligned with the sealing region of the cap wafer.

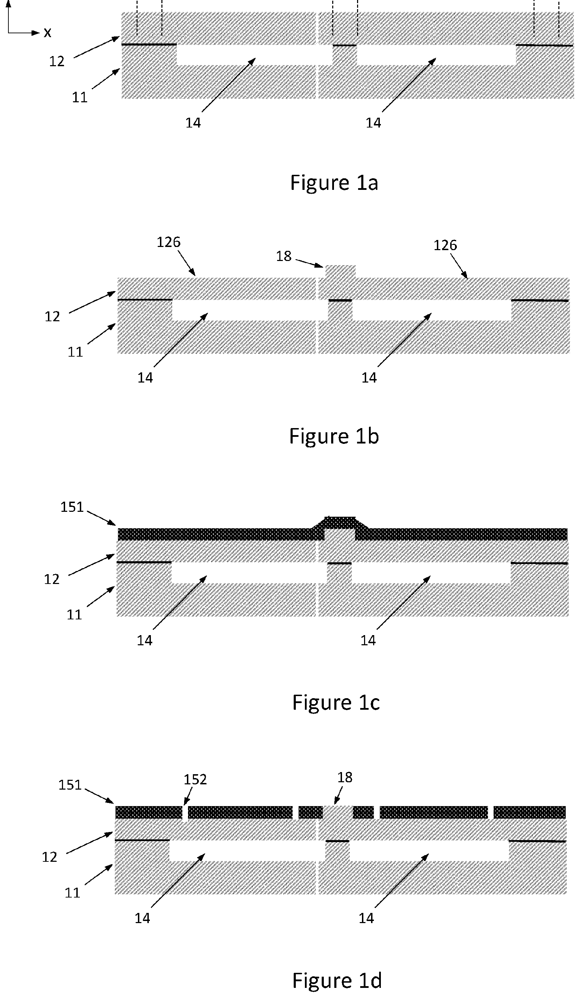

Figure 1a illustrates a silicon device wafer 12. The device wafer can for example be made of single crystal silicon or polycrystalline silicon. In this example case the device wafer 12 is attached to a handle wafer 11, and the handle wafer 11 and device wafer 12 together form a cavity-SOI wafer. In other words, the illustration shows a silicon-on-insulator wafer with one or more cavities 14 just below the surface of the device wafer 12. The device wafer could alternatively rest on some other kind of support. The cap wafer which will be described later may for example be a silicon wafer, a glass-silicon wafer, a GaAs wafer or a Ge wafer.

A sealing region 191 and an interconnection region 192 are illustrated on the surface of the device wafer 12 in figure 1a. The sealing region 191 encircles the region where the MEMS device structures are formed, which in this case coincides with the regions where the cavities 14 are located. The interconnection region 192 is where an electrical contact will be made to the cap wafer. The interconnection region 192 is here illustrated in the middle of the device in the x-direction, but it could be located anywhere in the xy-plane within the sealing region. There may be multiple interconnecting regions which are separately connected to the device wafer, even though only one is illustrated in these figures. Capacitive or piezoelectric transducers, which may actuate and/or measure the movement of the MEMS device structures, may be electrically connected to the interconnecting regions. The MEMS device structures may be formed in the device wafer before the steps of the sealing and contacting method are started. Alternatively, the MEMS device structures may be formed in the device wafer in conjunction with the sealing and contacting steps. The latter alternative is illustrated in the figures of this disclosure.

Figure 1b illustrates the device wafer 12 after a first conductive part 18 has been formed in the interconnection region on the top surface of the device wafer. The first conductive part 18 is a protrusion on the device wafer, so that its top surface is elevated in relation to the main surface 181. The first conductive part 18 may for example be a part of the device wafer itself, formed through one or more LOCOS oxidation processes, which can be used for recessing selected regions on the device wafer. The silicon device wafer is sufficiently conductive to be used as a part of the electrical connection between transducers and the outside world. Alternatively, the first conductive part could be formed by depositing a conductive material, for example polysilicon, on the surface of the device wafer and patterning that layer so that it is present only in the interconnection region.

Figure 1c illustrates the device after a layer 151 of a first diffusion-preventing material has been formed on the device wafer 12. The first diffusion-preventing material may for example be silicon dioxide or titanium nitride. A silicon dioxide layer may for example be formed by thermal oxidation. A layer of titanium nitride may be formed by depositing it on the device wafer. The thickness (in the z-direction) of the layer 151 of first diffusion-preventing material in the sealing region 191 may be equal or substantially equal to the height (in the z-direction) of the first conductive part 18 from the main surface 126 of the device wafer 12 in the interconnection region 192.

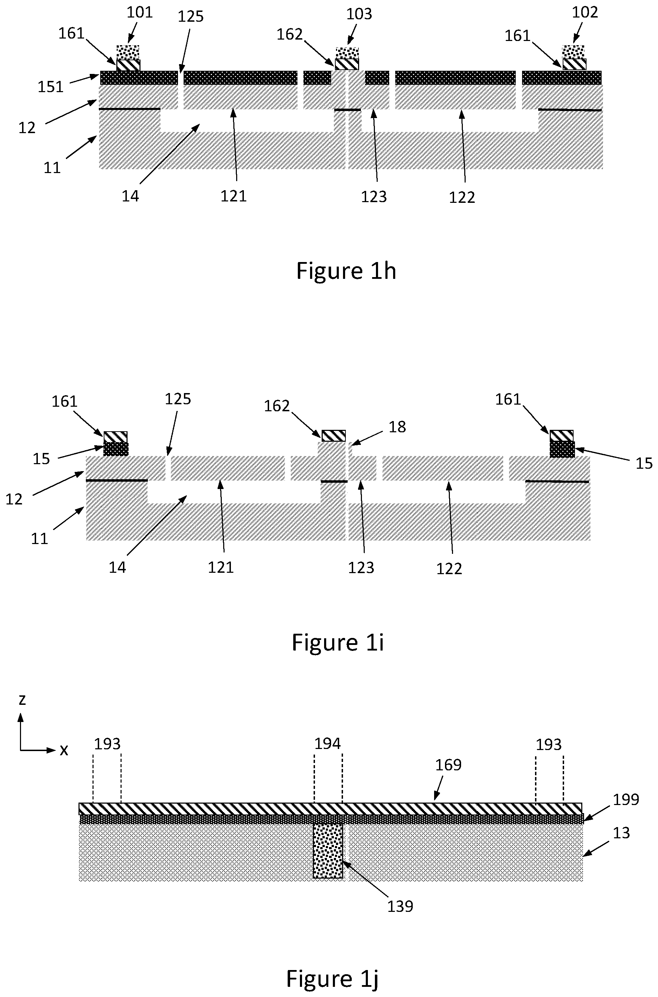

In figure 1i, the layer of the first diffusion-preventing material 151 is patterned so that it is present in the sealing region 191 on the device wafer. However, as figures 1d - 1h illustrate, the layer 151 may optionally be used also for other purposes before it is removed. In figure 1d, openings 152 have been made in this layer. A subsequent DRIE etch has then been performed through these openings in figure 1h to create MEMS device structures 121 and 122 in the device wafer.

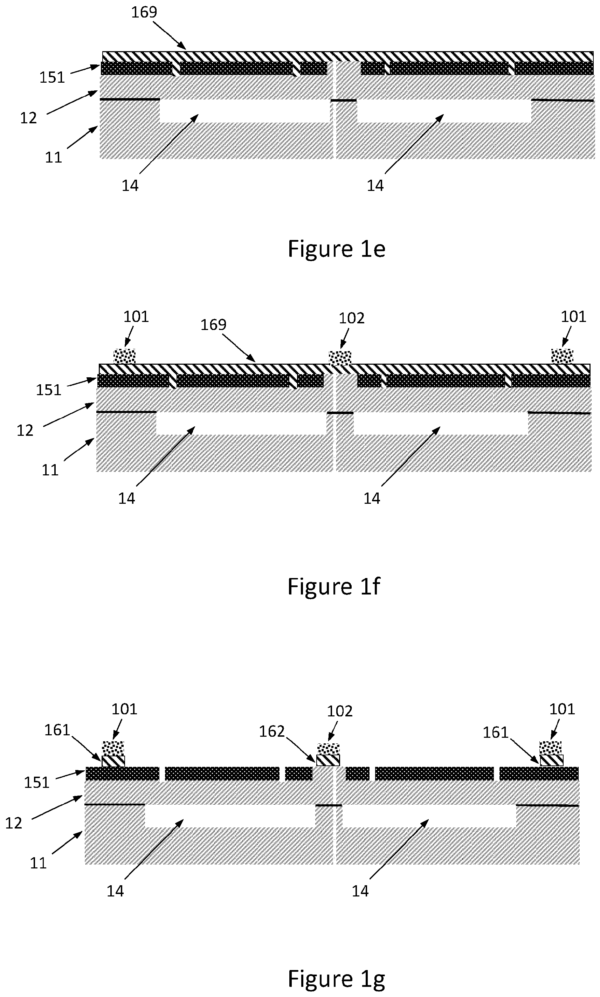

Figure 1e illustrates a device, where a layer 169 of a first eutectic metal alloy material has been deposited on the surface of the device wafer, for example by sputtering. The term "first eutectic metal alloy material" refers here to a layer of metal, which will later form one component in the eutectic metal alloy. Consequently, the material in layer 169 does not in itself need to be a metal alloy at this stage. If the eutectic metal alloy in the final product is AlGe, this first eutectic metal alloy material may be a layer of aluminium, or an AlCu alloy with a small percentage of copper, or a layer of germanium.

Figures 1f - 1g illustrate the patterning of layer 169. A mask layer 101 - 102 is deposited on top of the layer 169 of the first eutectic metal alloy material and patterned so that it protects the layer 169 in the interconnection region and in the sealing region. The rest of the layer 169 can then be removed. In figure 1g, the first eutectic metal alloy material is present in the sealing region 191 and in the interconnection region 192. The rest of the first diffusion-preventing material 151 can then also be removed from other areas on the surface of the device wafer, for example with HF treatment, so that it only remains in the interconnection region and in the sealing region.

Figure 1i illustrates the device wafer after this process has been completed. In the sealing region, a layer 161 of the first eutectic metal alloy material is stacked upon the first diffusion-preventing part 15 formed by the layer of first diffusion-preventing material. In the interconnection region, a layer 162 of the first eutectic metal alloy material is stacked upon the first conductive part 18. The height of the layer 151 above the main surface of the device wafer may be equal to the elevation of the first conductive part 18 above that same surface, so that the top surfaces of the layers 161 and 162 will also be at the same height.

Figures 1j - 1k illustrate the process steps, which are performed on the cap wafer. The processing of the cap wafer is performed independently of the device wafer processing until the two are joined. The cap wafer comprises a sealing region 193 and an interconnection region 194 on its top surface, as figure 1j illustrates. When the cap wafer is placed on top of the device wafer, these regions can be aligned with the corresponding regions on the device wafer, so that the stacks formed on the two wafers in these regions are in contact with each other in the bonding process.

The cap wafer comprises an electrical circuit. This circuit is illustrated simply with an electrically conductive vertical pillar 139 through the cap wafer, but it may in practice be much more complex, and it may comprise other layers on either surface of the cap wafer. The electrical circuit is connected to the interconnection region 194 on the surface of the cap wafer, so that the electrical connections formed to the interconnection region on the cap wafer also facilitate connections to the outside.

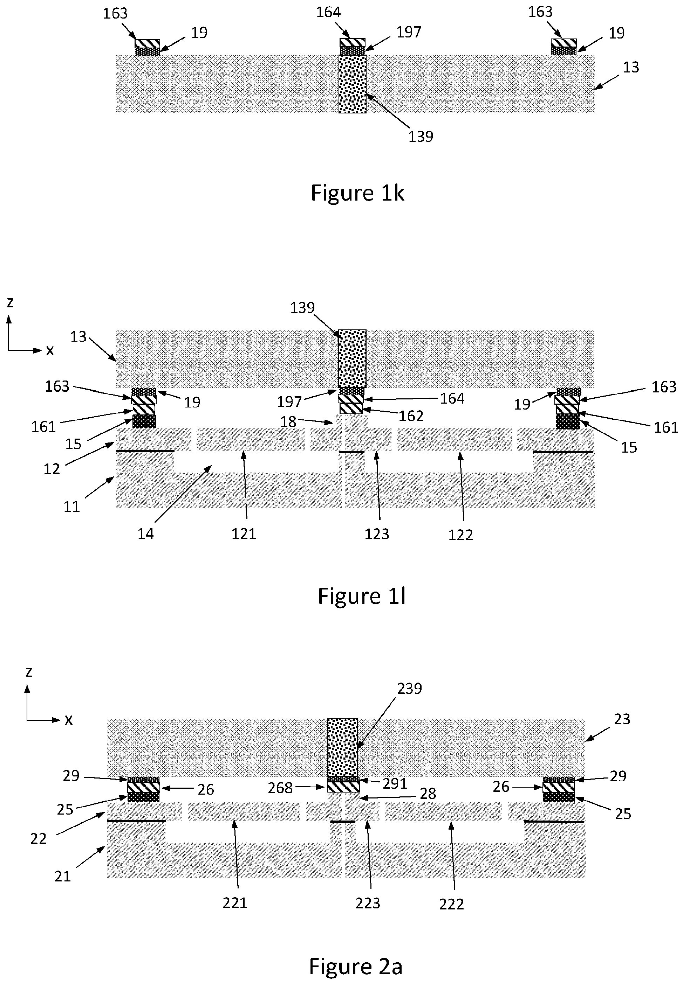

In figure 1j, an optional layer 199 of a second diffusion-preventing material has been deposited on the cap wafer 13, and a layer 169 of a second eutectic metal alloy material has then been deposited on top of the layer 199. In figure 1k, both of these layers have been patterned so that they form a second diffusion-preventing part 19, a second conductive part 197 in the interconnection region 194 and second layers 163 and 164 of the second eutectic metal alloy material in regions 193 and 194, respectively. Alternatively, the layer 169 of a second eutectic metal alloy material could be deposited on the cap wafer 13 without having the layer 199 beneath it. If the first eutectic metal alloy material is aluminium, the second eutectic metal alloy material may be germanium, and vice versa.

In others words, the following two steps may be performed before the second eutectic metal alloy material is deposited on the cap wafer: a second conductive part (197 in figure 1k) may be formed in the interconnection region of the cap wafer, and a layer of a second diffusion-preventing material may be deposited on the cap wafer and patterned so that it is present at least in the sealing region of the cap wafer, forming the second diffusion-preventing part 19 between the layer 163 and the cap wafer.

The step of forming a second conductive part in the interconnection region of the cap wafer may comprise the step of depositing a layer of conductive material on the cap wafer and patterning this layer so that it is present in the interconnection region of the cap wafer, and this conductive material and the second-diffusion-preventing material may be the same material. In practice, this means that the optional layer 199 of a second diffusion-preventing material could for example comprise aluminium, titanium or an aluminium / titanium alloy. The second diffusion-preventing material will prevent the diffusion of the second eutectic metal alloy material 169 into the cap wafer. Furthermore, since the optional layer 199 is in this case made of a conductive material, the second conductive part 197 can be formed by patterning the same layer. This arrangement has the benefit that the vertical heights of the second conductive part 197 and the second diffusion-preventing part can easily be made equal, which then allows the elevation of the second eutectic metal alloy layers 163 and 164 over the surface of the cap wafer to be made equal.

However, the conductive material that forms the second conductive part 197 could alternatively be different from the second diffusion-preventing material, which forms the parts 19 in figure 1k. The second diffusion-preventing material could be for example silicon dioxide, while the conductive material could be a metal. Two separate deposition processes would in this case have to be carried out to form the second conductive part 197 and the second-diffusion-preventing part 19 before the layer 169 of a second eutectic metal alloy material is deposited on the cap wafer. This option has not been illustrated.

Finally, the method comprises the step of bonding the cap wafer to the device wafer so that the interconnection region of the device wafer is aligned with the interconnection region of the cap wafer and the sealing region of the device wafer is aligned with the sealing region of the cap wafer. This has been illustrated in figure 1l, where the cap wafer has been turned around and aligned with the device wafer so that the first (161, 162) and second (163, 164) layers of eutectic metal alloy material can be bonded to each other to form a sealing eutectic metal alloy layer in the sealing region and an interconnecting eutectic metal alloy layer in the interconnection region. Reliable structures both for sealing the microelectromechanical device and for connecting it electrically to an external circuit have thereby been formed in the same metallic bonding process.

This metallic bonding process should be carried out at a temperature, which exceeds the eutectic temperature of the eutectic metal alloy. If AlGe is used as the eutectic metal alloy, a temperature of 440 - 450°C may for example be used. In general, the ratio between the vertical thickness of the aluminium layer and the vertical thickness of the germanium layer may beneficially be 0.59. All portions of both layers could then ideally form a part of the eutectic phase, which forms sealing the eutectic metal alloy layer 16 and the interconnecting eutectic metal alloy layer 168. Other thickness ratios will leave a residual layer of excess aluminium and/or germanium, as well as an intermediate hypoeutectic or hypereutectic phase, in the stack of layers. The ideal thickness ratio may also minimize squeeze-out effects, where excess material is pushed aside from the stack during the bonding process.

However, it is not always possible to implement the ideal thickness ratio. There may be limitations in the thicknesses that can be produced with a given deposition process, and the thicknesses of other device structures may place constraints on the thicknesses of the layers of first and second eutectic metal alloy materials. Furthermore, the duration of the metallic bonding process may, due to other constraints, be shorter than the formation of a pure eutectic phase would require.

Figure 2a illustrates a device where reference numbers 21, 22, 23, 25, 28, 29, 239, 268, and 291 correspond to reference numbers 11, 12, 13, 15, 18, 19, 139, 168, and 197, respectively, in figure 1l.

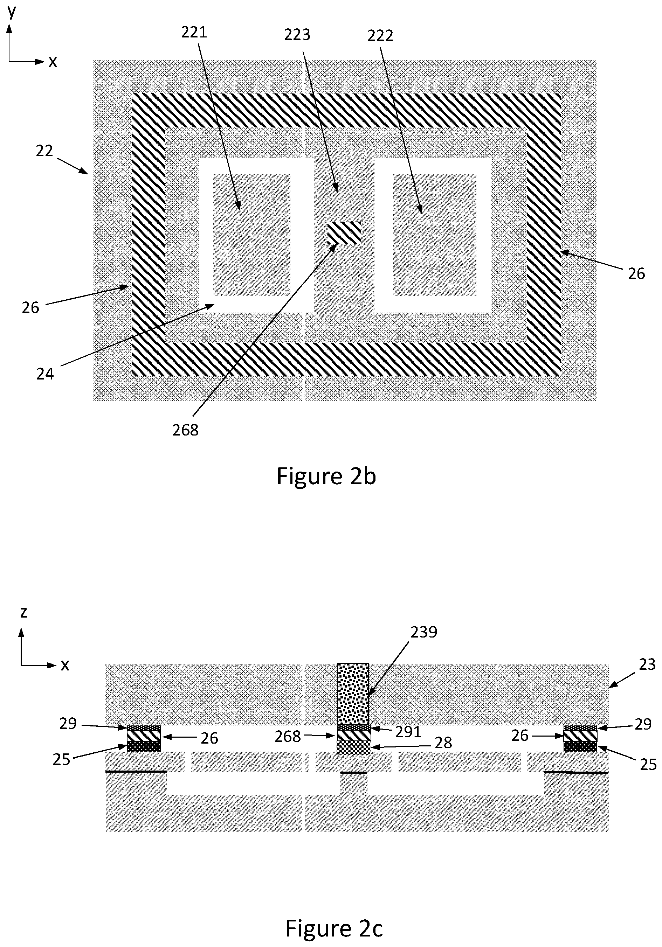

This microelectromechanical device comprises a silicon device wafer 22, which defines a device plane and a vertical direction which is perpendicular to the device plane, illustrated as the xy-plane in figure 2b. The device wafer comprises MEMS device structures 221 - 223 and a cap wafer 23 with an electrical circuit 239. The device wafer 22 is attached to the cap wafer 23 with a vertical sealing structure, which is substantially perpendicular to the device plane and surrounds the MEMS device structures in the device plane, so that the device structures are located in a cavity delimited at least by the device wafer, the cap wafer and the sealing structure. The device wafer is also attached to the cap wafer with a vertical electrical connector, which connects the MEMS device structures to the electrical circuit 239. The sealing structure comprises at least a first diffusion-preventing part 25, which is closer to the device wafer 22 and a sealing eutectic metal alloy layer 26, which is closer to the cap wafer 23. The electrical connector is connected to the electrical circuit, and the electrical connector comprises at least a first conductive part, which is closer to structures, which can move in relation to the rest of the device wafer. Structure 223 is a fixed part of the device wafer, as it is attached to underlying handle wafer 21. It may nevertheless be considered a MEMS device structure because it forms a part of the electrical connection. Force transducers, which are not illustrated in figures 2a - 2b, are also MEMS device structures, and they can be connected to the electrical connector illustrated in the middle of the device.

The eutectic metal alloy layers in the sealing regions of the device wafer and the cap wafer have in figure 2a been bonded to each other, so that they together form a sealing eutectic metal alloy layer 26, which seals the perimeter of the MEMS device. Correspondingly, the eutectic metal alloy layers in the interconnection regions of the device wafer and the cap wafer have been bonded to each other, so that they together form an interconnecting eutectic metal alloy layer 268, which electrically connects the active parts of the MEMS device, for example the transducers mentioned previously, to the electrical circuit 239 in the cap wafer.

As explained above, the second diffusion-preventing parts 29 are optional. Regardless of whether these parts are used or not, the simultaneous bonding of the sealing region and the interconnection region ensures that both the sealant and the electrical connection are reliable. Figure 2b illustrates the microelectromechanical device schematically in the xy-plane. The sealing eutectic metal alloy layer 26 surrounds device structures 221 - 223 in the device plane. The interconnecting eutectic metal alloy layer 268, which corresponds to the position of the vertical electrical connector in the xy-plane, could be placed on any fixed part of the device wafer 22. It does not necessarily have to be in the middle. Furthermore, there could be multiple vertical electric connectors with the same structure, as the one shown in figure 2a.

As mentioned previously, the first conductive part 28 may be a part of the device wafer 22, as in figure 2a, where it is a protrusion in the device wafer. Figure 2c illustrates an alternative configuration, where the first conductive part 28 is not a part of the device wafer. The layer 28 has instead been deposited on the surface of the device wafer 22. This layer may for example be a layer of polysilicon or any other sufficiently conductive material.

The vertical gap between the device wafer and the cap wafer may for example be in the range of 1.5 - 2.5 µm in the finished device. It is typically preferable to minimize any tilting of the cap wafer with respect to the device wafer during and after the metallic bonding process. This may be achieved with the means described earlier in this disclosure. The vertical height of the first diffusion-preventing part 25 may be substantially equal to the vertical height of the first conductive part 28. It can then be easily ensured that the layer of the first eutectic metal alloy material on the device wafer has the same thickness, and it extends to the same height in both the sealing region and the interconnection region. Similarly, the vertical height of the optional second diffusion-preventing part 29 may be substantially equal to the vertical height of the optional second conductive part 291. It can then be easily ensured that the layer of second eutectic metal alloy material on the cap wafer has the same thickness and extends to the same height above the surface of the cap wafer in both the sealing region and in the interconnection region. This will be the case, even if no second diffusion-preventing part 29 and second conductive part 291 is used, as the surface of the cap wafer is flat. Equally thick layers of the first and the second eutectic metal alloy materials in the sealing and interconnection region ensure that the sealing eutectic metal alloy layer and the interconnecting eutectic metal alloy layer will have substantially the same composition and thickness in the finished MEMS device.

However, the risk of tilting can in some cases be minimized further by building additional standoffs between the device wafer and the cap wafer. By fixing the distance between the device wafer and the cap wafer, such standoffs may also limit the compression of the eutectic metallic alloy layers during the bonding process. They thereby facilitate uniform thickness and uniform formation of the eutectic phase in the sealing eutectic metal alloy layer and the interconnecting eutectic metal alloy layer.

In a device with standoffs, the device wafer comprises a standoff region, and the cap wafer also comprises a corresponding standoff region. The method described above then comprises the following steps before the cap wafer is bonded to the device wafer: depositing a layer of first standoff material on the device wafer and patterning this layer so that it is present in the standoff region of the device wafer, and depositing a layer of second standoff material on the cap wafer and patterning this layer so that it is present in the standoff region of the cap wafer.

In a corresponding device, the device wafer is also attached to the cap wafer with one or more vertical standoffs, and each standoff comprises a first standoff layer and a second standoff layer, wherein the first standoff layer is closer to the device wafer and the second standoff layer is closer to the cap wafer.

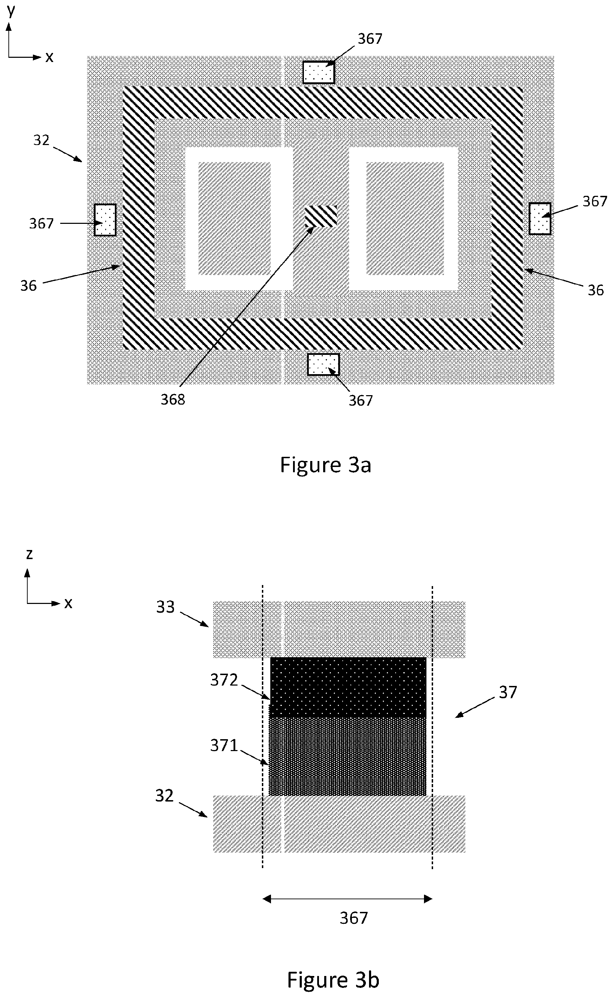

The standoff regions could be located anywhere in the device plane. Figure 3a illustrates a device, where the reference numbers 32, 36, and 368 correspond to the reference numbers 22, 26 and 268, respectively, in figure 2b. Standoff regions 367 are here located outside of the sealing region, so that the sealing region 36 lies between the standoff region 36 and the interconnection region 368. The standoff regions 367 may be placed symmetrically around the sealing region 36, as figure 3a illustrates. However, the sealing regions could alternatively be placed inside the sealing region, which may be desirable particularly if vertical standoffs should be included in the finished product. Vertical standoffs which lie outside of the sealing region may, if necessary, be removed after the metallic bonding process has been completed.

Figure 3b illustrates a standoff 37 between a device wafer 32 and a cap wafer 33. Prior to the metallic bonding process, a layer 371 of a first standoff material has been deposited on the device wafer and a layer 372 of a second standoff material has been deposited on the cap wafer. These two layers are then brought into contact with each other in the metallic bonding process, so that a vertical standoff 37 is formed.

The first standoff material and the first diffusion-preventing material may be the same material. The material may for example be silicon dioxide. Alternatively, it may be a metal such as aluminium. The layer 371 may therefore be formed in the same process where layer 15 in figure 1i is formed. The layer 372 of second standoff material may also be a layer of silicon dioxide. Additional layers, which may for example comprise the second diffusion-preventing material mentioned above, may also be included in the standoff. In general, the composition and thickness of the standoff should not be affected by the metallic bonding process. The standoffs can thereby set the height of the sealing and interconnecting eutectic metal alloy layers, which comprise multiple phases during the eutectic bonding process and can therefore be more difficult to control.

In any embodiment presented in this disclosure, the interconnecting eutectic metal alloy layer and the sealing eutectic metal alloy layer can be made of the same alloy. This material may be AlGe, as discussed earlier, or it may be AuSb, AuSi or CuSb. The first and second eutectic metal alloy materials can be chosen accordingly.

## Claims

1. A method for sealing and contacting a microelectromechanical device, wherein the device comprises a silicon device wafer (12, 22, 32) with **MEMS** device structures (121, 122, 221, 222) and a cap wafer (13, 23, 33) with an electrical circuit (139, 239), and the device wafer comprises a sealing region (191) and an interconnection region (192), and the cap wafer comprises a corresponding sealing region (193) and interconnection region (194), and the electrical circuit extends to the interconnect region in the cap wafer, and the method comprises the steps of:
- forming a first conductive part (18, 28) in the interconnection region of the device wafer so that the first conductive part is elevated above the main surface (126) of the device wafer,
- forming a layer of a first diffusion-preventing material (151) on the device wafer and patterning this layer so that it is present in the sealing region of the device wafer,
- depositing a layer of a first eutectic metal alloy material (169) on the device wafer and patterning this layer so that it is present in the interconnection region of the device wafer on top of the first conductive part and in the sealing region of the device wafer on top of the first diffusion-preventing material, and
- depositing a layer of a second eutectic metal alloy material (169) on the cap wafer and patterning this layer so that it is present in the interconnection region of the cap wafer and in the sealing region of the cap wafer, and
- bonding the cap wafer to the device wafer so that the interconnection region of the device wafer is aligned with the interconnection region of the cap wafer and the sealing region of the device wafer is aligned with the sealing region of the cap wafer.

2. A method according to claim 1, wherein the following two steps are performed before the second eutectic metal alloy material is deposited on the cap wafer:
- forming a second conductive part (197, 297) in the interconnection region of the cap wafer, and
- depositing a layer of a second diffusion-preventing material (199) on the cap wafer and patterning this layer so that it is present at least in the sealing region of the cap wafer.

3. A method according to claim 2, wherein the step of forming a second conductive part in the interconnection region of the cap wafer comprises the step of depositing a layer of conductive material (199) on the cap wafer and patterning this layer so that it is present in the interconnection region of the cap wafer, and this conductive material and the second-diffusion-preventing material are the same material.

4. A method according to any of claims 1-3, wherein the first conductive part is a part of the device wafer.

5. A method according to any of claims 1-4, wherein the device wafer also comprises a standoff region (367), and the cap wafer also comprises a corresponding standoff region, and the method comprises the following steps before the cap wafer is bonded to the device wafer:
- depositing a layer of first standoff material (371) on the device wafer and patterning this layer so that it is present in the standoff region of the device wafer, and
- depositing a layer of second standoff material (372) on the cap wafer and patterning this layer so that it is present in the standoff region of the cap wafer.

6. A method according to claim 5, wherein the first standoff material and the first diffusion-preventing material are the same material.

7. A microelectromechanical device comprising
- a silicon device wafer (12, 22, 32) which defines a device plane and a vertical direction which is perpendicular to the device plane, wherein the device wafer comprises MEMS device structures (121, 122, 221, 222) and
- a cap wafer (13, 23, 33) with an electrical circuit (139, 239),
wherein the device wafer is attached to the cap wafer with
- a vertical sealing structure which is substantially perpendicular to the device plane and surrounds the MEMS device structures in the device plane, so that the device structures are located in a cavity delimited at least by the device wafer, the cap wafer and the sealing structure, and
- a vertical electrical connector which connects the MEMS device structures to the electrical circuit,
wherein the sealing structure comprises at least a first diffusion-preventing part (15, 25) and a sealing eutectic metal alloy layer (26),
and the electrical connector is connected to the electrical circuit, wherein the electrical connector comprises at least a first conductive part (18, 28) which is closer to the device wafer and an interconnecting eutectic metal alloy layer (168, 268) which is closer to the cap wafer,
**characterized in that** in the sealing structure, the first diffusion-preventing part is closer to the device wafer and the sealing eutectic metal alloy layer is closer to the cap wafer.

8. A microelectromechanical device according to claim 7, wherein the sealing structure also comprises a second diffusion-preventing part (19, 29) which lies between the sealing eutectic metallic alloy layer and the cap wafer, and the electrical connector also comprises a second conductive part (197, 297) which lies between the first conductive part and the interconnecting eutectic metal alloy layer.

9. A microelectromechanical device according to claim 8, wherein the second diffusion-preventing part and the second conductive part are made of the same material.

10. A microelectromechanical device according to any of claims 7-9, wherein the first conductive part is a part of the device wafer.

11. A microelectromechanical device according to any of claims 7-10, wherein the device wafer is also attached to the cap wafer with one or more vertical standoffs (37), and each standoff comprises a first standoff layer (371) and a second standoff layer (372), wherein the first standoff layer is closer to the device wafer and the second standoff layer is closer to the cap wafer.

12. A microelectromechanical device according to claim 11, wherein the first standoff layer and the first diffusion-preventing layer are made of the same material.

## Patentansprüche

1. Verfahren zum Abdichten und Kontaktieren eines mikroelektromechanischen Bauelements, wobei das Bauelement einen Silicium-Bauelementwafer (12, 22, 32) mit MEMS-Bauelementstrukturen (121, 122, 221, 222) und einen Deckwafer (13, 23, 33) mit einer elektrischen Schaltung (139, 239) umfasst, und der Bauelementwafer eine Dichtungsregion (191) und eine Verschaltungsregion (192) umfasst, und der Deckwafer eine entsprechende Dichtungsregion (193) und Verschaltungsregion (194) umfasst, und die elektrische Schaltung sich bis zur Verschaltungsregion im Deckwafer erstreckt, und das Verfahren die folgenden Schritte umfasst:
- Ausbilden eines ersten leitenden Teils (18, 28) in der Verschaltungsregion des Bauelementwafers dergestalt, dass der erste leitende Teil über die Hauptoberfläche (126) des Bauelementwafers erhaben ist,
- Ausbilden einer Schicht eines ersten diffusionshemmenden Materials (151) auf dem Bauelementwafer und Strukturieren dieser Schicht dergestalt, dass sie in der Dichtungsregion des Bauelementwafers vorhanden ist,
- Auftragen einer Schicht eines ersten eutektischen Metalllegierungsmaterials (169) auf den Bauelementwafer und Strukturieren dieser Schicht dergestalt, dass sie in der Verschaltungsregion des Bauelementwafers oben auf dem ersten leitenden Teil und in der Dichtungsregion des Bauelementwafers oben auf dem ersten diffusionshemmenden Material vorhanden ist, und
- Auftragen einer Schicht eines zweiten eutektischen Metalllegierungsmaterials (169) auf den Deckwafer und Strukturieren dieser Schicht dergestalt, dass sie in der Verschaltungsregion des Deckwafers und in der Dichtungsregion des Deckwafers vorhanden ist, und
- Bonden des Deckwafers mit dem Bauelementwafer dergestalt, dass die Verschaltungsregion des Bauelementwafers mit der Verschaltungsregion des Deckwafers gefluchtet ist und die Dichtungsregion des Bauelementwafers mit der Dichtungsregion des Deckwafers gefluchtet ist.

2. Verfahren nach Anspruch 1, wobei die folgenden beiden Schritte ausgeführt werden, bevor das zweite eutektische Metalllegierungsmaterial auf den Deckwafer aufgetragen wird:
- Ausbilden eines zweiten leitenden Teils (197, 297) in der Verschaltungsregion des Deckwafers, und
- Auftragen einer Schicht eines zweiten diffusionshemmenden Materials (199) auf den Deckwafer und Strukturieren dieser Schicht dergestalt, dass sie mindestens in der Dichtungsregion des Deckwafers vorhanden ist.

3. Verfahren nach Anspruch 2, wobei der Schritt des Ausbildens eines zweiten leitenden Teils in der Verschaltungsregion des Deckwafers den Schritt umfasst: Auftragen einer Schicht von leitendem Material (199) auf den Deckwafer und Strukturieren dieser Schicht dergestalt, dass sie in der Verschaltungsregion des Deckwafers vorhanden ist, und es sich bei diesem leitenden Material und beim zweiten diffusionshemmenden Material um das gleiche Material handelt.

4. Verfahren nach einem der Ansprüche 1 bis 3, wobei der erste leitende Teil ein Teil des Bauelementwafers ist.

5. Verfahren nach einem der Ansprüche 1-4, wobei der Bauelementwafer auch eine Abstandshalterregion (367) umfasst, und der Deckwafer auch eine entsprechende Abstandshalterregion umfasst, und das Verfahren die folgenden Schritte umfasst, bevor der Deckwafer mit dem Bauelementwafer gebondet wird:
- Auftragen einer Schicht eines ersten Abstandshaltermaterials (371) auf den Bauelementwafer und Strukturieren dieser Schicht dergestalt, dass sie in der Abstandshalterregion des Bauelementwafers vorhanden ist, und
- Auftragen einer Schicht eines zweiten Abstandshaltermaterials (372) auf den Deckwafer und Strukturieren dieser Schicht dergestalt, dass sie in der Abstandshalterregion des Deckwafers vorhanden ist.

6. Verfahren nach Anspruch 5, wobei es sich beim ersten Abstandshaltermaterial und beim ersten diffusionshemmenden Material um das gleiche Material handelt.

7. Mikroelektromechanisches Bauelement umfassend:
- einen Silicium-Bauelementwafer (12, 22, 32), der eine Bauelementebene und eine vertikale Richtung senkrecht zur Bauelementebene definiert, wobei der Bauelementwafer MEMS-Bauelementstrukturen (121, 122, 221, 222) umfasst, und
- einen Deckwafer (13, 23, 33) mit einer elektrischen Schaltung (139, 239),
wobei der Bauelementwafer am Deckwafer angebracht ist und zwar mit
- einer vertikalen Dichtungsstruktur, die im Wesentlichen senkrecht zur Bauelementebene ist und die MEMS-Bauelementstrukturen in der Bauelementebene umgibt, so dass die Bauelementstrukturen in einer durch den Bauelementwafer, den Deckwafer und die Dichtungsstruktur abgegrenzten Vertiefung angeordnet sind, und
- einem vertikalen elektrischen Verbinder, der die MEMS-Bauelementstrukturen mit der elektrischen Schaltung verbindet,
wobei die Dichtungsstruktur mindestens einen ersten diffusionshemmenden Teil (15, 25) und eine abdichtende eutektische Metalllegierungsschicht (26) umfasst
und der elektrische Verbinder mit der elektrischen Schaltung verbunden ist, wobei der elektrische Verbinder mindestens einen ersten leitenden Teil (18, 28), der näher am Bauelementwafer ist, und eine verschaltende eutektische Metalllegierungsschicht (168, 268), die näher am Deckwafer ist, umfasst,
**gekennzeichnet dadurch, dass** in der Dichtungsstruktur der erste diffusionshemmende Teil näher am Bauelementwafer ist und die abdichtende eutektische Metalllegierungsschicht näher am Deckwafer ist.

8. Mikroelektromechanisches Bauelement nach Anspruch 7, wobei die Dichtungsstruktur auch einen zweiten diffusionshemmenden Teil (19, 29) umfasst, der zwischen der abdichtenden eutektischen Metalllegierungsschicht und dem Deckwafer liegt, und der elektrische Verbinder auch einen zweiten leitenden Teil (197, 297) umfasst, der zwischen dem ersten leitenden Teil und der verschaltenden eutektischen Metalllegierungsschicht liegt.

9. Mikroelektromechanisches Bauelement nach Anspruch 8, wobei der zweite diffusionshemmende Teil und der zweite leitende Teil aus dem gleichen Material gefertigt sind.

10. Mikroelektromechanisches Bauelement nach einem der Ansprüche 7 bis 9, wobei der erste leitende Teil ein Teil des Bauelementwafers ist.

11. Mikroelektromechanisches Bauelement nach einem der Ansprüche 7 bis 10, wobei der Bauelementwafer auch mit einem oder mehreren vertikalen Abstandshaltern (37) am Deckwafer angebracht ist und jeder Abstandshalter eine erste Abstandshalterschicht (371) und eine zweite Abstandshalterschicht (372) umfasst, wobei die erste Abstandshalterschicht näher am Bauelementwafer ist und die zweite Abstandshalterschicht näher am Deckwafer ist.

12. Mikroelektromechanisches Bauelement nach Anspruch 11, wobei die erste Abstandshalterschicht und die erste diffusionshemmende Schicht aus dem gleichen Material gefertigt sind.

## Revendications

1. Procédé pour sceller et contacter un dispositif microélectromécanique, dans lequel le dispositif comprend une tranche de dispositif de silicium (12, 22, 32) avec des structures de dispositif MEMS (121, 122, 221, 222) et une tranche de couverture (13, 23, 33) avec un circuit électrique (139, 239), et la tranche de dispositif comprend une zone de scellement (191) et une zone d'interconnexion (192), et la tranche de couverture comprend une zone de scellement (193) et zone d'interconnexion (194) correspondantes, et le circuit électrique s'étend jusqu'à la zone d'interconnexion dans la tranche de couverture, et le procédé comprend les étapes suivantes consistant à :
- former une première partie conductrice (18, 28) dans la zone d'interconnexion de la tranche de dispositif de telle sorte que la première partie conductrice est élevée au-dessus de la surface principale (126) de la tranche de dispositif,
- former une couche d'un premier matériau empêchant la diffusion (151) sur la tranche de dispositif et modeler ladite couche de telle sorte qu'elle est présente dans la zone de scellement de la tranche de dispositif,
- déposer une couche d'un premier matériau d'alliage métallique eutectique (169) sur la tranche de dispositif et modeler ladite couche de telle sorte qu'elle est présente dans la zone d'interconnexion de la tranche de dispositif au-dessus de la première partie conductrice et dans la zone de scellement de la tranche de dispositif au-dessus du premier matériau empêchant la diffusion, et
- déposer une couche d'un deuxième matériau d'alliage métallique eutectique (169) sur la tranche de couverture et modeler ladite couche de telle sorte qu'elle est présente dans la zone d'interconnexion de la tranche de couverture et dans la zone de scellement de la tranche de couverture, et
- assembler la tranche de couverture à la tranche de dispositif de telle sorte que la zone d'interconnexion de la tranche de dispositif est alignée sur la zone d'interconnexion de la tranche de couverture et la zone de scellement de la tranche de dispositif est alignée sur la zone de scellement de la tranche de couverture.

2. Procédé selon la revendication 1, dans lequel les étapes suivantes sont effectuées avant le dépôt du deuxième matériau d'alliage métallique eutectique sur la tranche de couverture :
- former une deuxième partie conductrice (197, 297) dans la zone d'interconnexion de la tranche de couverture, et
- déposer une couche d'un deuxième matériau empêchant la diffusion (199) sur la tranche de couverture et modeler ladite couche de telle sorte qu'elle est présente au moins dans la zone de scellement de la tranche de couverture.

3. Procédé selon la revendication 2, dans lequel l'étape consistant à former une deuxième partie conductrice dans la zone d'interconnexion de la tranche de couverture comprend l'étape consistant à déposer une couche d'un matériau conducteur (199) sur la tranche de couverture et modeler ladite couche de telle sorte qu'elle est présente dans la zone d'interconnexion de la tranche de couverture, et ledit matériau conducteur et le deuxième matériau empêchant la diffusion sont le même matériau.

4. Procédé selon l'une des revendications 1 à 3, dans lequel la première partie conductrice est une partie de la tranche de dispositif.

5. Procédé selon l'une des revendications 1 à 4, dans lequel la tranche de dispositif comprend également une zone d'espacement (367), et la tranche de couverture comprend également une zone d'espacement correspondante, et le procédé, avant l'assemblage de la tranche de couverture à la tranche de dispositif, comprend les étapes suivantes consistant à :
- déposer une couche d'un premier matériau d'espacement (371) sur la tranche de dispositif et modeler ladite couche de telle sorte qu'elle est présente dans la zone d'espacement de la tranche de dispositif, et
- déposer une couche d'un deuxième matériau d'espacement (372) sur la tranche de couverture et modeler ladite couche de telle sorte qu'elle est présente dans la zone d'espacement de la tranche de couverture.

6. Procédé selon la revendication 5, dans lequel le premier matériau d'espacement et le premier matériau empêchant la diffusion sont le même matériau.

7. Dispositif microélectromécanique comprenant
- une tranche de dispositif de silicium (12, 22, 32) qui définit un plan de dispositif et une direction verticale qui est perpendiculaire au plan de dispositif, ladite tranche de dispositif comprenant des structures de dispositif MEMS (121, 122, 221, 222), et
- une tranche de couverture (13, 23, 33) avec un circuit électrique (139, 239),
dans lequel la tranche de dispositif est attachée à la tranche de couverture avec
- une structure de scellement verticale qui est essentiellement perpendiculaire au plan de dispositif et entoure les structures de dispositif MEMS dans le plan de dispositif de telle sorte que les structures de dispositif sont disposées dans une cavité délimitée au moins par la tranche de dispositif, la tranche de couverture et la structure de scellement, et
- un connecteur électrique vertical qui connecte les structures de dispositif MEMS au circuit électrique,
dans lequel la structure de scellement comprend au moins une première partie empêchant la diffusion (15, 25) et une couche d'alliage métallique eutectique de scellement (26),
et le connecteur électrique est connecté au circuit électrique, ledit connecteur électrique comprenant au moins une première partie conductrice (18, 28) qui est plus proche de la tranche de dispositif et une couche d'alliage métallique eutectique d'interconnexion (168, 268) qui est plus proche de la tranche de couverture,
**caractérisé en ce que**, dans la structure de scellement, la première partie empêchant la diffusion est plus proche de la tranche de dispositif et la couche d'alliage métallique eutectique de scellement est plus proche de la tranche de couverture.

8. Dispositif microélectromécanique selon la revendication 7, dans lequel la structure de scellement comprend également une deuxième partie empêchant la diffusion (19, 29) qui est située entre la couche d'alliage métallique eutectique de scellement et la tranche de couverture, et le connecteur électrique comprend également une deuxième partie conductrice (197, 297) qui est située entre la première partie conductrice et la couche d'alliage métallique eutectique d'interconnexion.

9. Dispositif microélectromécanique selon la revendication 8, dans lequel la deuxième partie empêchant la diffusion et la deuxième partie conductrice sont faites du même matériau.

10. Dispositif microélectromécanique selon l'une des revendications 7 à 9, dans lequel la première partie conductrice est une partie de la tranche de dispositif.

11. Dispositif microélectromécanique selon l'une des revendications 7 à 10, dans lequel la tranche de dispositif est attachée à la tranche de couverture également avec un ou plusieurs espacements verticaux (37), et chaque espacement comprend une première couche d'espacement (371) et une deuxième couche d'espacement (372), la première couche d'espacement étant plus proche de la tranche de dispositif et la deuxième couche d'espacement étant plus proche de la tranche de couverture.

12. Dispositif microélectromécanique selon la revendication 11, dans lequel la première couche d'espacement et la première couche empêchant la diffusion sont faites du même matériau.
